# EUROPEAN PATENT APPLICATION

(11) **EP 4 378 749 A1**
(43) Date of publication of application: **05.06.2024**
(21) Application number: 23209265.0
(22) Date of filing: 10.11.2023
(51) Int. Cl.: B60L 58/12

(54) **BATTERY MONITORING SYSTEM AND METHOD FOR ELECTRIC MARINE PROPULSION**

(30) Priority: 11.11.2022 US 202263383393 P; 08.11.2023 US 202318504505
(71) Applicant: Brunswick Corporation, Mettawa, Illinois 60045 (US)
(72) Inventor: Baer, Mitchell J., Fond du Lac, WI 54937 (US); Kalnins, Jared D., Neenah, WI 54956 (US); Osthelder, Robert R., Winneconne, WI 54986 (US); Neveau, Lukas G., Oshkosh, WI 54902 (US); Phelps, Bradley J., Fond du Lac, WI 54935 (US)
(74) Representative: Sandersons

(57) **Abstract**

An electric marine propulsion system (2) includes a power storage system (16) comprising at least one marine battery (18a-d), an electric marine drive (3) powered by the power storage system (16), a display (40), and a control system (11). The control system (11) is configured to receive a reported time to empty (reported TTE) from each of the at least one battery (18a-d) and/or receive a battery current from each of the at least one battery (18a-d), upon detection of an update condition, update at least one of a smoothed time to empty (smoothed TTE) value (101) and a smoothed distance to empty (smoothed DTE) value (201) for the power storage system (16) based on the reported TTE and/or the battery current from each of the at least one battery (18a-d), and control the display (40) to display the smoothed TTE value (101) and/or the smoothed DTE value (201).

## Description

### FIELD

The present disclosure generally relates to marine propulsions systems, and more particularly to electric marine propulsion systems having battery-powered electric motors and methods for monitoring and reporting remaining battery power.

### BACKGROUND

Electric propulsion systems comprising an electric motor rotating a propeller are known. For example, on-board electric drive systems and outboard electric drive systems have been developed for propelling marine vessels. Different power supply arrangements for powering electric propulsion systems are also known. Such power storage systems includes one or more batteries or banks of batteries, and may include other storage devices such as one or more ultracapacitors, fuel cells, flow batteries, and other devices capable of storing and outputting electric energy.

The following U.S. Patent publications provide background information.

U.S. Publication No. 2023/0219675 discloses a method of controlling an electric marine propulsion system to propel a marine vessel that includes receiving a user-set time, determining a time remaining based on the user-set time, and identifying a battery charge level of a power storage system on the marine vessel. A required battery power is then determined based on the time remaining and the battery charge level, and then an output limit is determined based on the required battery power to enable propelling the marine vessel for the user-set time without recharging the power storage system. The propulsion system is automatically controlled so as not to exceed the output limit.

U.S. Publication No. 2023/0219676 discloses a method of controlling an electric marine propulsion system configured to propel a marine vessel that includes receiving a user-set distance, identifying a battery charge level of a power storage system on a marine vessel and identifying an energy utilization value. An output limit is then determined based on a remaining distance, the battery charge level, and the energy utilization value. The propulsion system is then automatically controlled so as to not exceed the output limit, enabling the marine vessel to travel the user-set distance without recharging the power storage system.

### SUMMARY

This Summary is provided to introduce a selection of concepts that are further described below in the Detailed Description. This Summary is not intended to identify key or essential features of the claimed subject matter, nor is it intended to be used as an aid in limiting the scope of the claimed subject matter.

In one aspect of the disclosure, an electric marine propulsion system includes a power storage system comprising at least one marine battery, an electric marine drive powered by the power storage system, a display, and a control system. The control system is configured to receive a reported time to empty (reported TTE) from each of the at least one battery and/or receive a battery current from each of the at least one battery, upon detection of an update condition, update at least one of a smoothed time to empty (smoothed TTE) value and a smoothed distance to empty (smoothed DTE) value for the power storage system based on the reported TTE and/or the battery current from each of the at least one battery, and control the display to display the smoothed TTE value and/or the smoothed DTE value.

In another aspect of the disclosure, a method of monitoring a power storage system configured to power an electric marine propulsion system includes, receiving a reported time to empty (reported TTE) from each of the at least one battery and/or receiving a battery current from each of the at least one battery and detecting an update condition. Upon detecting the update condition, steps include updating at least one of a smoothed time to empty (smoothed TTE) value and a smoothed distance to empty (smoothed DTE) value for the power storage system based on the reported TTE and/or the battery current from each of the at least one battery, and controlling a display to display the smoothed TTE value and/or the smoothed DTE value.

Optionally, the detected update condition includes at least one of a threshold change in demand, a neutral motor state, a threshold change in battery current, a threshold change in a filtered TTE value, a threshold change in vessel speed, engagement of an over-torque state, or disengagement of the over-torque state.

Optionally, an estimated TTE is determined as a current-conditioned time to empty (current-conditioned TTE) calculated based on a battery current received from all of the at least one battery, and wherein the control system is further configured to determine a total battery current being drawn from the power storage system and a total capacity remaining for the power storage system. Upon detection of the update condition, the total battery current at a time of detecting the update condition is passed through and the current-conditioned TTE for the marine battery is calculated based on the total battery current and the total capacity remaining.

Optionally, the smoothed DTE value is based on the smoothed TTE value and the display is controlled in real time to update the smoothed TTE value and the smoothed DTE value.

Optionally, the power storage system includes at least two marine batteries, and wherein the total battery current is determined as a sum of an individual battery current of the at least two marine batteries wherein the total capacity remaining is determined as a sum of the individual capacity remaining in amp-hours of the at least two marine batteries.

Optionally, the control system is further configured to calculate the smoothed DTE value based on the smoothed TTE value and a filtered vessel speed.

In another aspect of the disclosure, a method of monitoring a power storage system of an electric marine propulsion system is provided, wherein the power storage system comprises at least one marine battery. The method includes calculating a filtered time to empty (TTE) estimate for the power storage system based on a reported TTE received from all of the at least one battery and/or a current-conditioned TTE calculated based on a battery current received from all of the at least one battery. Upon detection of a update condition, the filtered TTE estimate at a time of detecting the update condition is passed through to generate an output-conditioned TTE, and a display associated with the marine propulsion system is controlled to display the output-conditioned TTE.

In another aspect of the disclosure, a method of monitoring a power storage system of an electric marine propulsion system is provided, wherein the power storage system comprises at least one marine battery. The method includes determining an estimated time to empty (TTE) based on the reported TTE from all of the at least one battery and/or based on a battery current received from all of the at least one battery, filtering the estimated TTE based on a propulsion output value to generate a filtered TTE estimate, upon detection of an update condition, passing through the filtered TTE estimate at a time of detecting the update condition to generate a conditioned TTE, and controlling a display to display a smoothed TTE value that is updated based on the conditioned TTE.

Optionally, the propulsion output value includes at least one of a motor RPM, a motor current, and a motor torque of a powerhead of the electric marine drive.

Optionally, the update condition includes occurrence of at least one of a threshold change in demand, a neutral motor state, a threshold change in battery current, a threshold change in a filtered TTE value, a threshold change in vessel speed, engagement of an over-torque condition, or disengagement of the over-torque condition.

Optionally, the threshold change in demand is one of a threshold change in demand magnitude since the smoothed TTE value was last updated based on the conditioned TTE or a threshold rate of change in demand.

In another aspect of the disclosure, a method of monitoring a power storage system of an electric marine propulsion system for a marine vessel is provided, wherein the power storage system comprises at least one marine battery. The method includes determining a total battery current being drawn from the power storage system and a total capacity remaining for the power storage system, upon detection of a update condition, pass through the total battery current at a time of detecting the update condition, calculating a conditioned time to empty (TTE) for the marine battery based on the total battery current and the total capacity remaining, and controlling a display to display a smoothed TTE value that is updated based at least in part on the current-conditioned TTE.

Optionally, the method further includes filtering the conditioned TTE based on a propulsion output value to generate a filtered TTE estimate, upon detection of the update condition, passing through the filtered TTE estimate at a time of detecting the update condition to generate an output-conditioned TTE, and controlling the display to display a smoothed TTE value that is updated further based on the output-conditioned TTE.

Optionally, the update condition includes the occurrence of at least one of a threshold rate of change in demand, a neutral motor state, a threshold change in battery current, a threshold change in a filtered TTE, or a threshold change in vessel speed.

In another aspect of the present disclosure, a method of monitoring a power storage system of an electric marine propulsion system is provided, wherein the power storage system comprises at least one marine battery. The method includes determining a filtered vessel speed based on a propulsion output value, upon detection of a update condition, pass through the filtered vessel speed at the time of detecting the update condition, calculating a smoothed distance to empty (DTE) value based on the filtered vessel speed and a time to empty (TTE) for the power storage system, and controlling a display to display the smoothed DTE value.

Optionally, the TTE for the power storage system is based on a filtered total battery current for the marine vessel.

Optionally, the TTE for the power storage system is determined by applying a filter to an estimated TTE based on a propulsion output value.

Optionally, the estimated TTE is a total reported TTE calculated as an average or a filtered average of the reported TTE from all of the at least one battery.

Optionally, the estimated TTE is calculated based on a battery current received from all of the at least one battery.

Optionally, filtering the estimated TTE includes applying a longer filter when the propulsion output value is low than when the propulsion output value is high.

### BRIEF DESCRIPTION OF THE DRAWINGS

The present disclosure is described with reference to the following Figures.
FIG. 1 is a schematic depiction of a marine vessel having an exemplary electric marine propulsion system in accordance with the present disclosure.
FIG. 2 depicts another exemplary electric marine propulsion system in accordance with the present disclosure.
FIG. 3 illustrates a set of charge level and battery current reported values for each of a plurality of batteries in a power storage system.
FIG. 4 is a control diagram illustrating an exemplary method for monitoring a power storage system according to the present disclosure.
FIGS. 5-7 are control diagrams illustrating exemplary steps for determining a smoothed time to empty value according to the present disclosure.
FIGS. 8-9 are control diagrams illustrating exemplary steps for determining a smoothed distance to empty value according to the present disclosure.
FIGS. 10-11 are control diagrams illustrating additional exemplary embodiments for determining a smoothed time to empty value according to the present disclosure.

### DETAILED DESCRIPTION

The inventors have recognized that, in order address the heightened issues with range anxiety faced with electric marine propulsion, a consistent and reliable reporting of remaining battery life to the user is needed in a way that allows the user to judge how much operation time and travel distance can be accomplished before the battery is empty. The inventors have further recognized that the data used to calculate time to empty and distance to empty values can be noisy and inconsistent, including being overly influenced by transient changes in the environment and/or within the propulsion system. This results in time and distance to empty values reported to gauges also being noisy and reporting ever-changing and sometimes rapidly changing and widely varying consecutive values. Upon extensive market research, time and distance to empty value on a display that is changing rapidly was determined to be a customer dissatisfier. Accordingly, the inventors developed the disclose strategy and system for calculating a smoothed time to empty (smoothed TTE) value and a smoothed distance to empty (smoothed DTE) value. Various filtering and latching strategies are used to remove noisy and inconsistent values from the smoothed TTE and DTE calculation to provide consistent and reliable information to a user regarding battery life remaining.

The inventors have endeavored to design an electric marine propulsion system with a modular power storage system where customers have the ability to add and remove batteries to increase the power storage capabilities and extend the range of the propulsion system. In doing so, the inventors have recognized a problem with electric marine propulsion systems having a plurality of separately controlled batteries where charge level imbalances or differing conditions across the batteries lead to even noisier and widely varying TTE and DTE values. The disclosed methods and systems for calculating a smoothed TTE and smoothed DTE values remediate this problem for a multi-battery system and are adaptable for any number of one or more batteries. This disclosed system and method are configured to provide a single TTE number and a single DTE number for all batteries in the power storage system such that the user is given a reliable and understandable remaining power value that avoids the problems with noise described above.

As disclosed herein, a marine propulsion system and power monitoring method are provided that update and display a smoothed TTE and/or a smoothed DTE upon occurrence of a update condition. In various embodiments, the update condition may be at least one of a threshold change in demand, a neutral motor state, a threshold change in current, a threshold change in the reported time to empty from any of the at least one battery, or a threshold change in vessel speed. Alternatively or additionally, the update condition may be engagement or disengagement of an over-torque state providing boosted propulsion output for a short duration to accelerate the marine vessel. One exemplary embodiment of boosted motor output is shown and described in U.S. Application No. 17/672,054. Upon detection of the update condition, the smoothed TTE value and/or the smoothed DTE value for the power storage system are updated based on the reported time to empty and/or the battery current from each of the at least one battery at the time of detecting the update condition. The display is then controlled to provide the updated smoothed TTE and/or smoothed DTE values.

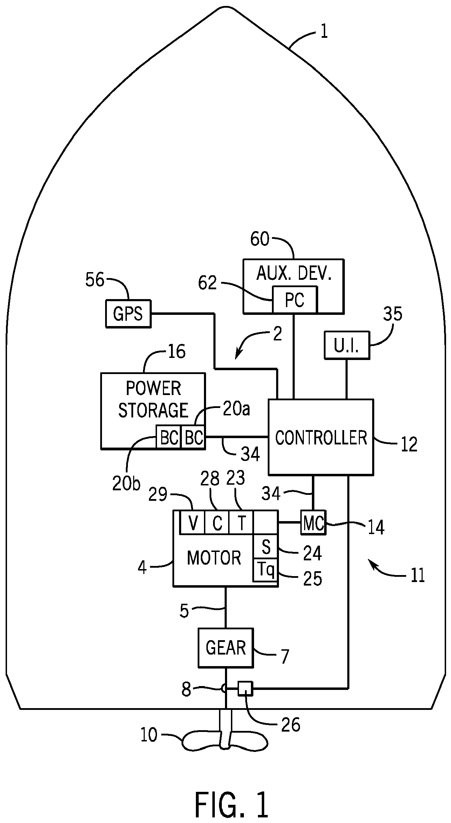

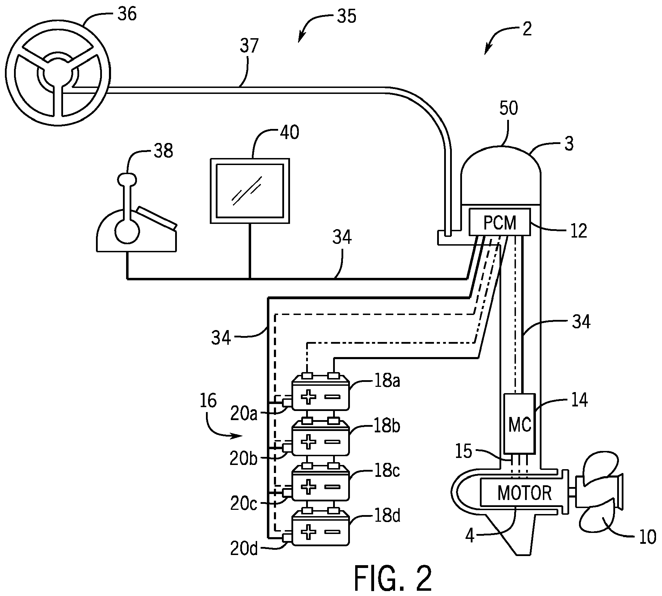

FIG. 1 depicts an exemplary embodiment of a marine vessel 1 having an electric marine propulsion system 2 configured to propel the marine vessel in a direction instructed by an operator via a steering control system, or by a guidance system configured to automatically control steering of the marine vessel to steer the vessel toward a predetermined location or global position. Referring also to FIG. 2, embodiments of the electric propulsion system 2 include at least one electric marine drive 3 having an electric motor 4 configured to propel the marine vessel 1 by rotating a propeller 10, as well as a power storage system 16, and a user interface system 35. In the depicted embodiment of FIG. 2, the electric marine propulsion system 2 includes an outboard marine drive 3 having an electric motor 4 powerhead housed therein, such as housed within the cowl 50 of the outboard marine drive. A person of ordinary skill in the art will understand in view of the present disclosure that the marine propulsion system 2 may include other types of electric marine drives 3, such as inboard drives or stern drives. The electric marine drive 3 is powered by the scalable storage system 16, such as including a plurality of batteries 18 connected in parallel.

The electric marine propulsion system 2 may include one or a plurality of electric marine drives 3, each comprising at least one electric motor 4 powerhead configured to rotate a propulsor, or propeller 10. The motor 4 may be, for example, a brushless electric motor, such as a brushless DC motor. In other embodiments, the electric motor may be a DC brushed motor, an AC brushless motor, a direct drive, a permanent magnet synchronous motor, an induction motor, or any other device that converts electric power to rotational motion. In certain embodiments, the electric motor 4 includes a rotor and a stator in a known configuration.

The electric motor 4 is electrically connected to and powered by a power storage system 16. The power storage system 16 stores energy for powering the electric motor 4 and is rechargeable, such as by connection to shore power when the electric motor 4 is not in use. Various power storage devices and systems are known in the relevant art. The power storage system 16 includes a plurality of batteries 18 or banks of batteries. For example, plurality of batteries 18 or banks of batteries may be arranged in parallel. The power storage system 16 may include a plurality of lithium-ion (LI) batteries 18, each LI battery 18 comprised of multiple battery cells. In other embodiments, the power storage system 16 may include a plurality of lead-acid batteries 18, fuel cells, flow batteries, ultracapacitors, and/or other devices capable of storing and outputting electric energy.

Each battery 18a-18d may include an associated battery controller 20a-20d configured to identify a battery charge level and other battery parameters for that battery, such as battery temperature, battery current, battery voltage, battery state of health (SOH) and battery state of charge (SOC), and to determine an individual time to empty (TTE) based on some or all of the forgoing parameters (e.g., based on battery current and battery state of charge and/or battery voltage). Each controller 20a-20d may also be configured to control whether the respective battery 18a-18d is connected to deliver power, and thus active, or is inactive and disconnected from and not delivering power to the marine drive(s) 3. For example, if a limit set for temperature, power, current, or other parameter for the battery 18a-18d is exceed, then the controller 20a-20c may be configured to disconnect the battery 18a-18d in order to protect it from damage. Where a battery 18a-18d is in an inactive state, the respective controller 20a-20d may be configured to communicate a current and/or power limit of zero and/or to communicate an error indicating that the battery 18a-18d is not active or available to provide power.

The electric motor 4 is operably connected to the propeller 10 and configured to rotate the propeller 10. As will be known to the ordinary skilled person in the relevant art, the propeller 10 may include one or more propellers, impellers, or other propulsor devices and that the term "propeller" may be used to refer to all such devices. In certain embodiments, such as that represented in FIG. 1, the electric motor 4 may be connected and configured to rotate the propeller 10 through a gear system 7 or a transmission. In such an embodiment, the gear system 7 translates rotation of the motor output shaft 5 to the propeller shaft 8 to adjust conversion of the rotation and/or to disconnect the propeller shaft 8 from the drive shaft 5, as is sometimes referred to in the art as a "neutral" position where rotation of the drive shaft 5 is not translated to the propeller shaft 8. Various gear systems 7, or transmissions, are well known in the relevant art. In other embodiments, the electric motor 4 may directly connect to the propeller shaft 8 such that rotation of the drive shaft 5 is directly transmitted to the propeller shaft 8 at a constant and fixed ratio.

As described above, the power storage system 16 may include a battery controller 20a-20d for each battery 18a-18d in the system, each battery controller 20a-20d configured to monitor and/or control the respective battery. The battery controller 20a-20d is be configured to receive information from current, voltage, and/or other sensors within the respective battery 18a-18d, such as to receive information about the voltage, current, and temperature of each battery cell or group of battery cells. For example, the battery controller 20a-20d may receive inputs from one or more sensors, such as one or more voltage, current, and temperature sensors within a housing for the battery 18a-18d. Voltage sensors may be configured to sense voltage within the battery (such as cell voltage sensors configured to sense the voltage of individual cells or groups of cells in a LI battery) and one or more temperature sensors may be configured to sense a temperature within a housing. The battery controller 20a-20d is configured to calculate a charge level, such as a state of charge and/or a voltage (such as an open circuit voltage), of the battery 18a-18d, and may also be configured to determine a battery state of health and a current temperature for the battery 18a-18d. The battery controller 20a-20d may be further configured to determine a power limit for the battery 18a-18d, which is an amount of power that the battery 18a-18d can supply without overheating, over discharging, or otherwise compromising the battery. The battery controllers 20a-20d may be configured to communicate those values via a communication link 34 to other control devices in a control system 11.

A control system 11 controls the electric marine propulsion system 2, wherein the control system 11 may include a plurality of control devices configured to cooperate to provide the method of controlling the electric marine propulsion system described herein. For example, the control system 11 includes a central controller 12, a plurality of battery controllers 20a-20d, and one or more motor controllers 14, trim controllers, steering controllers, etc. communicatively connected, such as by a communication bus. A person of ordinary skill in the art will understand in view of the present disclosure that other control arrangements could be implemented and are within the scope of the present disclosure, and that the control functions described herein may be combined into a single controller or divided into any number of a plurality of distributed controllers that are communicatively connected.

Each controller may comprise a processor and a storage device, or memory, configured to store software and/or data utilized for controlling and or tracking operation of the electric propulsion system 2. The memory may include volatile and/or non-volatile systems and may include removable and/or non-removable media implemented in any method or technology for storage of information. The storage media may include non-transitory and/or transitory storage media, including random access memory, read only memory, or any other medium which can be used to store information and be accessed by an instruction execution system, for example. An input/output (I/O) system provides communication between the control system 11 and peripheral devices.

Each electric motor 4 may be associated with a motor controller 14 configured to control power to the electric motor, such as to the stator winding thereof. The motor controller 14 is configured to control the function and output of the electric motor 4, such as controlling the torque outputted by the motor, the rotational speed of the motor 4, as well as the input current, voltage, and power supplied to and utilized by the motor 4. In one arrangement, the motor controller 14 controls the current delivered to the stator windings via the leads 15, which input electrical energy to the electric motor to induce and control rotation of the rotor.

In certain embodiments, various sensing devices 23-25, 26, and 28-29, may be configured to communicate with a local controller, such as the motor controller 14 or battery controller 20a-20d, and in other embodiments the sensors 23-25, 26, and 28-29 may communicate with the central controller 12 and one or more of the motor controller 14 and or battery controller 20a-20d may be eliminated. A GPS system 55 may also be configured to determine a current global position of the vessel, track vessel position over time, and/or determine vessel speed and direction of travel, and to provide such information to the controller 12. Alternatively or additionally, vessel speed may be measured by a speed-over-water sensor such as a pitot tube or a paddle wheel and such information may be provided to the controller 12. Controllers 12, 14, 20a-20d (and or the various sensors and systems) may be configured to communicate via a communication bus such as a CAN bus or a LIN bus, or by single dedicated communication links between controllers 12, 14, 20a-20d.

Sensors may be configured to sense the power, including the current and voltage, delivered to the motor 4-i.e., motor current and motor voltage. For example, a voltage sensor 29 may be configured to sense the input voltage to the motor 4 and a current sensor 28 may be configured to measure input current to the motor 4. Accordingly, power delivered to the motor 4 can be calculated and such value can be used for monitoring and controlling the electric propulsion system 2, including for monitoring and controlling the motor 4. In the depicted example, the current sensor 28 and voltage sensor 29 may be communicatively connected to the motor controller 14 to provide measurement of motor current-i.e., the current supplied to the motor-and motor voltage-i.e., voltage across the inputs to the motor, respectively. The motor controller 14 is configured to provide appropriate current and or voltage to meet the demand for controlling the motor 4. For example, a demand input may be received at the motor controller 14 from the central controller 12, such as based on an operator demand at a helm input device, such as the throttle lever 38. In certain embodiments, the motor controller 14, voltage sensor 29, and current sensor 28 may be integrated into a housing of the electric motor 4, in other embodiments the motor controller 14 may be separately housed.

Various other sensors may be configured to measure and report parameters of the electric motor 4. For example, the electric motor 4 may include means for measuring and or determining the torque, rotation speed (motor speed), current, voltage, temperature, vibration, or any other parameter. In the depicted example, the electric motor 4 includes a temperature sensor 23 configured to sense a temperature of the motor 4, a rotational speed sensor 24 configured to measure a rotational speed of the motor 4 (motor RPM), and a torque sensor 25 for measuring the torque output of the motor 4. A propeller speed sensor 26 may be configured to measure a rotational speed of the propeller shaft 8, and thus rotational speed of the propeller 10. For example, the propeller speed sensor 26 and/or the motor speed sensor 24 may be a Hall Effect sensor or other rotation sensor, such as using capacitive or inductive measuring techniques. In certain embodiments, one or more of the parameters, such as the speed, torque, or power to the electric motor 4, may be calculated based on other measured parameters or characteristics. For example, the torque may be calculated based on motor current and/or other power characteristics in relation to the rotation speed of the electric motor, for example.

The central controller 12, which in the embodiment shown in FIG. 2 is a propulsion control module (PCM), communicates with the motor controller 14 via communication link 34, such a serial communication bus or other type of communication network (which may be a wired or wireless network implementation). To provide one example, the communication link 34 may be a CAN bus, such as a Kingdom Network. The controller also receives input from and/or communicates with one or more user interface devices in the user interface system 35 via the communication link, which in some embodiments may be the same communication link as utilized for communication between the controllers 12, 14, 20a-20d or may be a separate communication link. The user interface devices in the exemplary embodiment include a throttle lever 38 and a display 40. In various embodiments, the display 40 may be, for example, part of an onboard management system, such as the VesselView^{™} by Mercury Marine of Fond du Lac, Wisconsin. In other examples, the display 40 may be provided elsewhere on the vessel, such as on the housing of the marine drive 3 or on a user's mobile device, such as operating an application that interfaces with the control system 11 (e.g., VesselView Mobile^{™} by Mercury Marine). A steering wheel 36 is provided, which in some embodiments may also communicate with the controller 12 in order to effectuate steering control over the marine drive 3, which is well-known and typically referred to as steer-by-wire arrangements. In the depicted embodiment, the steering wheel 36 is a steer arrangement where the steering wheel 36 is connected to a steering actuator that steers the marine drive 3 by a steering cable 37. Other steer arrangements, such as various steer-by-wire arrangements, are well-known in the art and could alternatively be implemented. Likewise, the drive 3 may be steered by other means or arrangements, such as a tiller handle or a foot pedal, which are both well-known in the relevant art.

The various parameters of the electric propulsion system are utilized for providing monitoring and reporting functionality on the power storage system. The power storage system 16 may further be configured to power auxiliary devices 60 on the marine vessel 1 that are not part of the propulsion system 2. For example, the auxiliary devices may include a bilge pump, a cabin lights, a stereo system or other entertainment devices on the vessel, a water heater, a refrigerator, an air conditioner or other climate/comfort control devices on the vessel, communication systems, navigation systems, or the like. Some or all of these accessory devices are sometimes referred to as a "house load" and may consume a substantial amount of battery power. The power consumption by some or all of the auxiliary devices may be monitored, such as by one or more power controllers 62 associated with one or a group of auxiliary devices (FIG. 1). The power controller 62 is communicatively connected to the controller 12 or is otherwise communicating with one or more controllers in the control system 11 to communicate information about power consumption by such auxiliary devices. For example, the power controller 62 may be configured to communicate with one or more power monitoring or other control devices via CAN bus or LIN bus.

The system 2 may be configured to account for all power utilization, including for propulsion and auxiliary devices, by utilizing battery current and charge level parameters and provide information on the remaining battery power in the form of a time to empty (TTE) and/or a distance to empty (DTE) value for the power storage system 16, including all of the plurality of batteries 18a-18d. Smoothed TTE and DTE values are calculated and refreshed upon occurrence of a update condition, and various calculation methods are described herein.

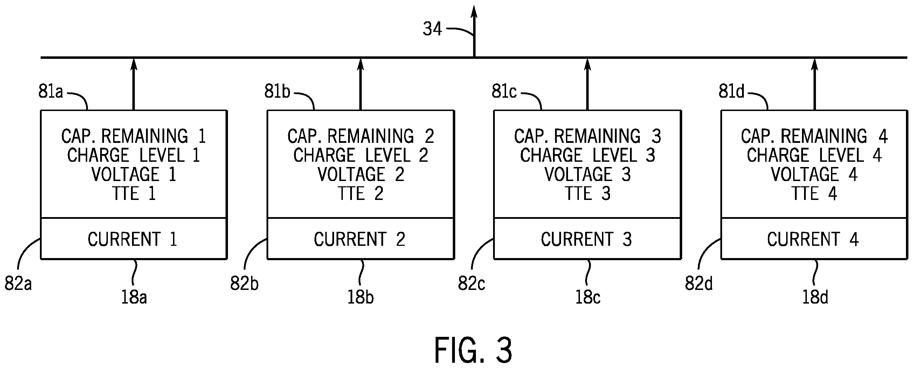

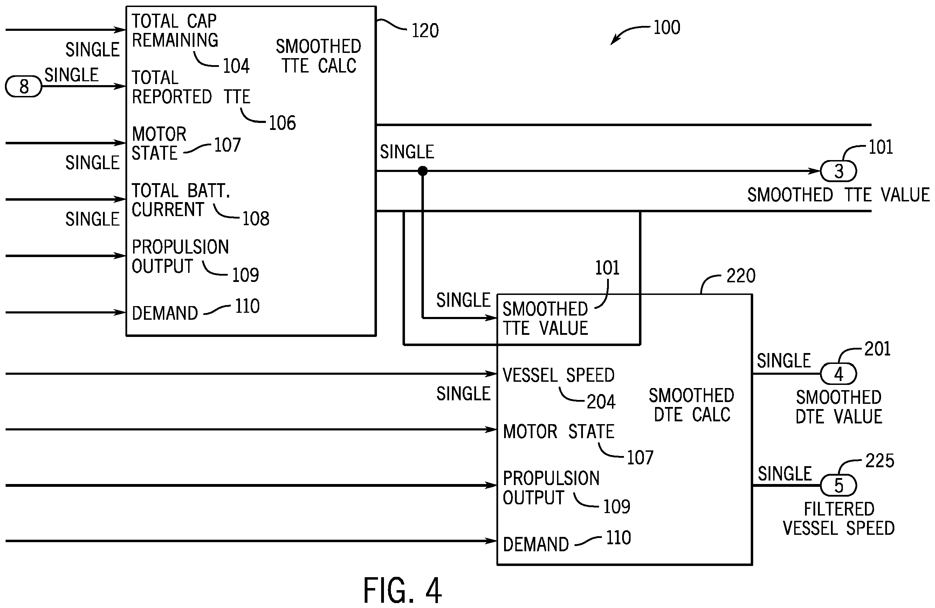

The diagrams at FIGS. 3-9 illustrate exemplary control routines executed by the control system 11 for monitoring the power storage system 16, including calculation of a smoothed TTE and/or smoothed DTE value that can be displayed to the user, e.g., on display 40 associated with the propulsion system 2. In the example at FIG. 3, each of a plurality of batteries-being four batteries-in the power storage system is reporting individual charge level values 81a-d and battery current values 82a-d for the respective battery 18a-d. The charge level values 81a-d and battery current values 82a-d are provided by each battery controller 20a-d to the central controller 12 via the communication link 34, which are provided as inputs to the control methods 100 exemplified at FIGS. 4-9. The charge level values 81a-d include information about the remaining battery power of the individual battery, such as battery voltages 1-4, battery charge levels (e.g., SOC) 1-4, capacity remaining 1-4 (e.g., in amp hours), and the individual battery TTEs 1-4 (e.g., in minutes).

FIG. 4 depicts one embodiment of a method 100 of monitoring a power storage system 16 where a smoothed TTE value 101 is first calculated by calculation module 120, and a smoothed DTE value 201 is then calculated based on the smoothed TTE value 101 and measured vessel speed 204. Total charge level and current inputs are calculated based on each individual reported battery value, including a total capacity remaining 104, total reported TTE 106, and a total battery current 108. The total capacity remaining 104 is calculated based on the individual capacity remaining values 1-4. In one embodiment, the total capacity remaining 104 is calculated as the sum of the individual capacity remaining values 1-4. The total reported TTE 106 is calculated based on the reported individual battery TTE 1-4 from each of the at least one battery 18a-d, such as the average of the individual capacity remaining values 1-4, or may be a filtered average, such as to remove outlier values or to remove reported TTE values for batteries 18a-d that are not providing power. The total battery current 108 is calculated based on the battery current 1-4 values 82a-82d reported from each battery 18a-d, such as a sum of the individual battery currents 82a-82d. Other battery charge level values, such as SOC, may also be provided and corresponding totals calculated. For example, a total SOC may be determined based on the individual battery SOCs, such as an average of the individual SOCs of the batteries operating in the power storage system 16.

Other inputs are provided, including a demand value 110 indicative of propulsion demand input and propulsion output value 109 indicative of propulsion output of the propulsion output of the marine drive 3, such as motor RPM, motor current, or motor torque. The demand value 110 indicates a propulsion demand input-e.g., from a user, a speed control system (e.g., cruise control or autonomous propulsion control), etc.-commanding operation of the motor. For example, the demand value 110 may be a lever position, a tiller position, or the position of some other user input device operable to control output of the motor 4. For example, the operator demand may be a percentage value (0-100%) between zero propulsion output command (associated with 0%) and a maximum propulsion output command (100%) based on a rotational position of the control lever 38 or a tiller (not shown), such as a percentage of the maximum rotational position in a particular direction, which may correlate to a commanded propulsion output value, such as motor RPM, motor torque, or motor current. A motor state 107 value indicative of an operation state (e.g., run or off) of the motor 4 is also provided as an input, such as from the motor controller 14.

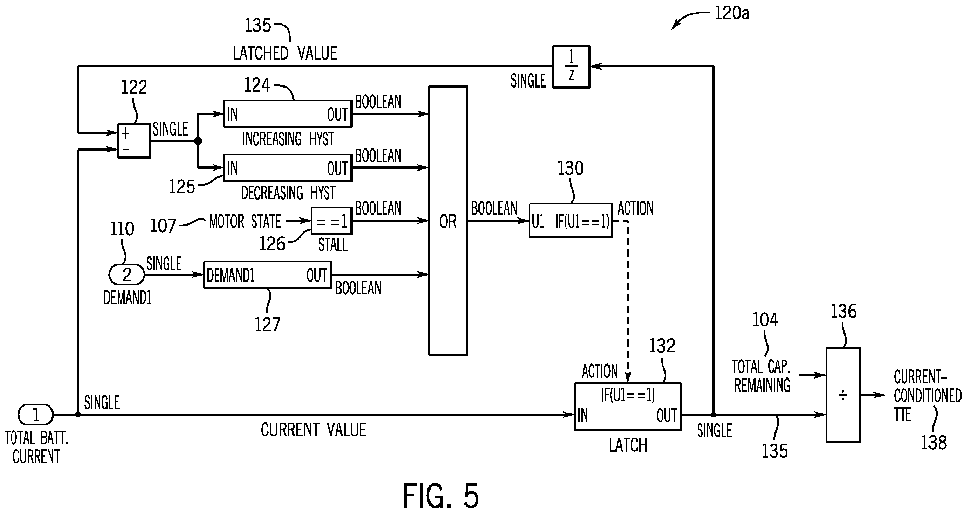

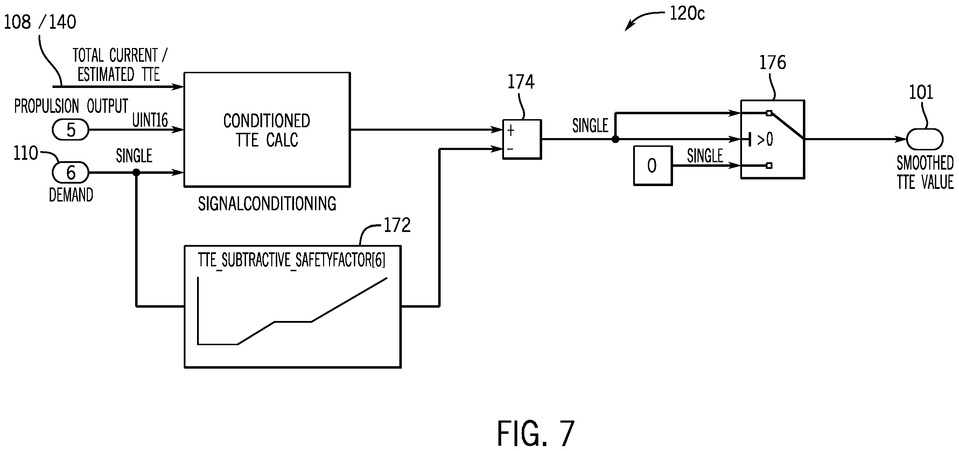

The smoothed TTE calculation block 120 determines the smoothed TTE 101 based on the total remaining capacity 104, the total reported TTE 106, the motor state 107, the total battery current 108, the propulsion output value 109, and the demand 110. Logic for the smoothed TTE calculation block 120 is exemplified in FIGS. 4-6, which includes outputting an updated smoothed TTE value 101 upon detection of at least one of a predetermined list of update conditions, such as a threshold rate of change in demand, a threshold change in current (which may be a threshold increase or a threshold decrease), a threshold change in the total reported TTE (which may be a threshold increase or a threshold decrease), or a neutral motor state (i.e., motor is off). The smoothed DTE 201 is calculated based on the smoothed TTE 101 at smoothed DTE calculation block 220. Logic for the smoothed TTE calculation block 120 is exemplified in FIGS. 7-9, which includes outputting an updated smoothed DTE value 201 upon detection of at least one of a predetermined list of update conditions, such as a threshold rate of change in demand or a threshold change in vessel speed (which, as explained further below, may be a threshold increase or a threshold decrease in a filtered vessel speed). In some embodiments, the smoothed DTE value 201 may be calculated on a different TTE input, such as a filtered TTE or some other TTE calculation that is different than any of the ones depicted in FIGS. 5-7.

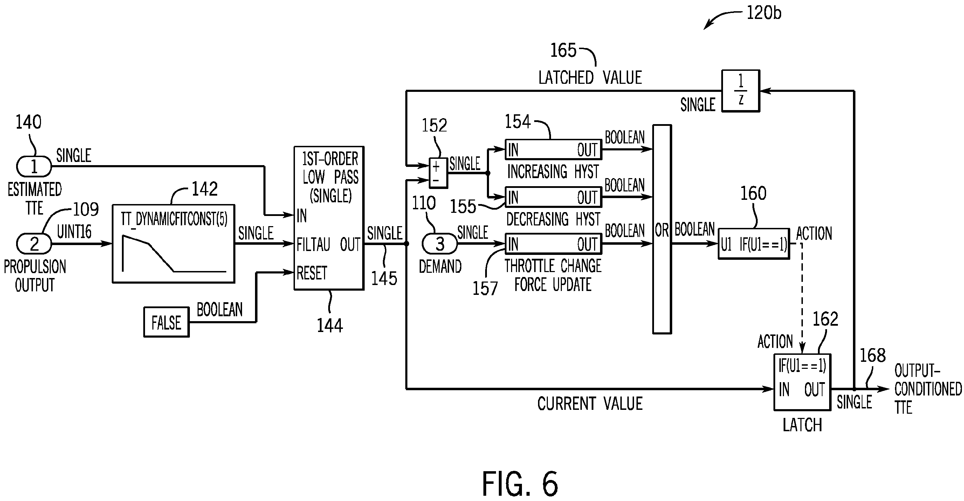

FIG. 5 is a control diagram showing one embodiment of a conditioned TTE calculation that can be used alone as a smoothed TTE calculation, or in conjunction with the conditioning steps shown in FIGS. 6 and/or 7. In FIG. 5, a current-conditioned TTE is calculated by process 120a based on the total battery current 108 and total remaining capacity 104. Logic is performed to determine whether an update condition has occurred, and thus whether a new current value should be latched for purposes of determining the current-conditioned TTE 138. The total battery current 108 is provided as input, which as described above is determined based on the individual battery currents reported by the battery controllers 20a-d. For example, the total battery current value 108 may be inputted and the latching logic performed at a frequency of about 5 ms or 10 ms, or it could be a longer period.

The total battery current 108 is passed to difference block 122 which calculates a difference between the last-provided total battery current 108 and a latched current value 135. The outputted difference is assessed at the increasing hysteresis block 124 and decreasing hysteresis block 125, which are configured to assess whether a threshold change in battery current has occurred. Namely, the difference value is compared to a current increase threshold at block 124 to identify whether the total battery current 108 has increased by a predetermined material threshold. The difference value is compared to a current decrease threshold at block 125 to identify whether the total battery current 108 has decreased by a predetermined material threshold. The threshold increase and threshold decrease values may be individually definable such that they can differ-i.e., the threshold for triggering latch based on an increasing value may be different than the threshold for triggering latch based on a decreasing value. If either of those conditions are true, then a "1" or true condition is outputted from the respective block 124, 125 and a new current value will be latched.

Also as part of the latching logic, block 127 is performed to determine whether a threshold rate of change in the demand 110 has occurred. Here, logic is executed to determine whether a rapid change has occurred in the demand input, such as a significant movement of the throttle lever or tiller handle (or other user input device), that warrants an immediate update in the current-conditioned TTE calculation. For example, the latest demand value 110 may be compared to a filtered demand value, such as generated using a first order lowpass filter, to determine whether a threshold rate of change has occurred. Alternatively, other logic may be executed to determine whether a threshold demand change has occurred. The threshold utilized may be a calibratable fixed value, or in some embodiments may be a user-adjustable value to enable a user to adjust how responsive the displayed TTE value is to changes in demand. Alternatively or additionally, the update condition may be engagement or disengagement of an over-torque state providing boosted propulsion output for a short duration to accelerate the marine vessel.

In this example, block 126 is performed to determine whether the motor state 107 is off, or not running. If so, then a then a "1" or true condition is outputted and a new current value will be latched. This is because much of the "noise" and transient changes in current are due to the motor 4 activity, and thus the input value may be less problematic when the motor 4 is not running. However, in other embodiments, the motor-state-based part of the latching logic may be eliminated, such as where large auxiliary loads may come on or offline and may cause similar noisy current draws.

If any of the values at blocks 124-127 are true, as determined at block 130, then the update condition is met and a new current value is latched at step 132 by passing through the latest total battery current value 108 and making that the new latched value 135. The current-conditioned TTE 138 is then calculated at step 136 based on the new current value, which is calculated as the total capacity remaining 104 divided by the latched current value 135. If the total capacity remaining is in Amp hours, then the current-conditioned TTE 138 is calculated in hours. In some embodiments, this may be multiplied by 60 so as to be reported in minutes.

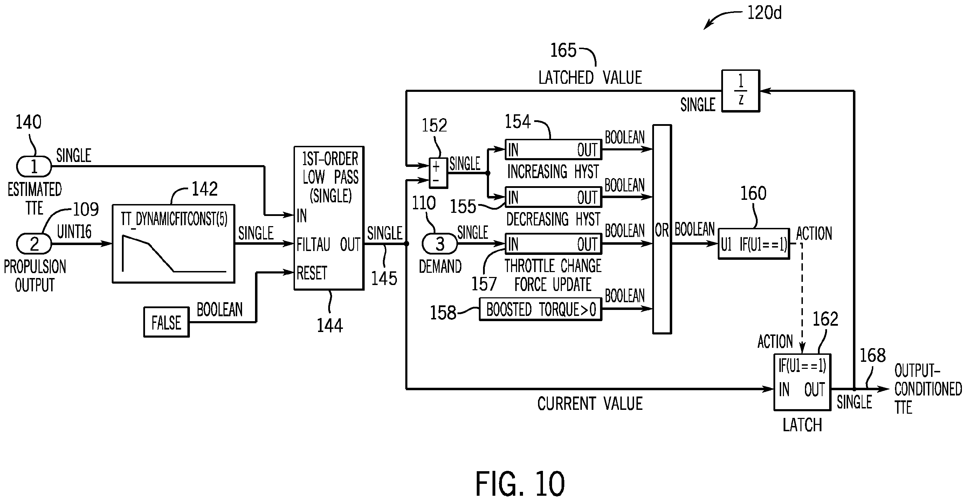

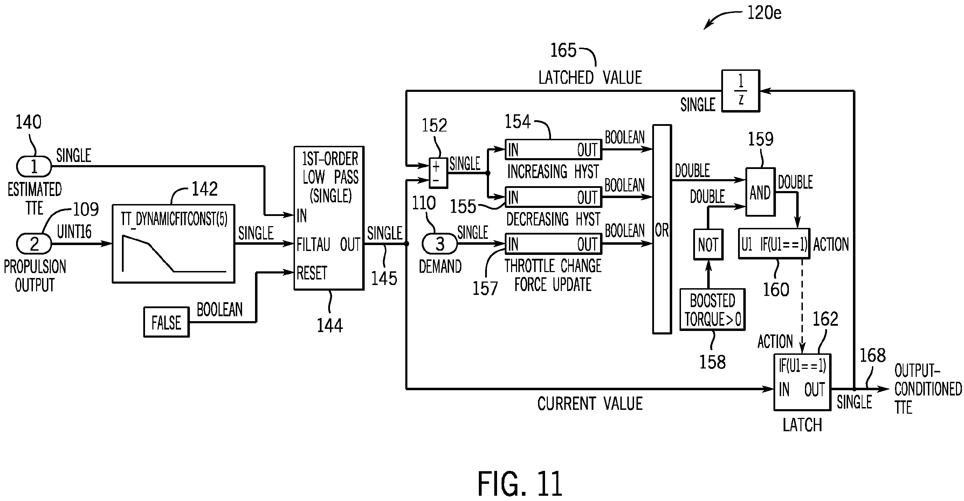

FIG. 6 is control diagram showing another embodiment of a conditioned TTE calculation that can be used alone as a smoothed TTE calculation, or in conjunction with the conditioning method steps shown in FIGS. 5 and/or 7. In FIG. 6, an output-conditioned TTE 168 is calculated by process 120b based on an estimated TTE 140. FIGS. 10 and 11 demonstrate additional exemplary processes for calculating output-conditioned TTE 168. The estimated TTE is calculated based on total battery values of all of the batteries 18a-d in the power storage system 16, such as based on battery current, or may be at total reported TTE 106 calculated based on the individual reported TTEs 1-4 from the batteries 18a-d. Alternatively, the estimated TTE may be calculated based on the total battery current 108, such as the current-conditioned TTE 138 described herein. Alternatively, the estimated TTE for the power storage system 16 may be calculated by other means.

The estimated TTE 140 is filtered at block 144 using a dynamic filter selected at block 142 based on the propulsion output value 109, such as a motor RPM, motor current, or motor torque. For example, block 142 my include a lookup of filters based on propulsion output values, and is configured to provide a longer and/or more aggressive filtering for propulsion output values 109 on the lower end of the spectrum than on the higher end. Thus, a longer filter may be applied when the propulsion output value is low than when the propulsion output value is high, and the filter length selected at block 142 may progressively decrease as the propulsion output value 109 increases.

The filtered TTE estimate 145 outputted from block 144 is then subjected to latching logic similar to that described above. The filtered TTE estimate 145 is passed to difference block 152 which calculates a difference between the latest filtered TTE estimate 145 and a latched estimate value 165. The difference outputted from block 152 is assessed at the increasing hysteresis block 154 and decreasing hysteresis block 155, which are configured to assess whether a threshold change has occurred. For example, where the estimated TTE is a total reported TTE 106, then the hysteresis blocks 154 and 155 determine whether a threshold change in reported TTE has occurred, as filtered based on the propulsion output value 109. Namely, the difference value is compared to an increase threshold at block 154 to identify whether the filtered TTE estimate 145 has increased by a predetermined material threshold. The difference value is compared to a decrease threshold at block 155 to identify whether the output-filtered TTE estimate 145 has decreased by a predetermined material threshold. The threshold increase and threshold decrease values may be individually definable such that they can differ-i.e., the threshold for triggering latch based on an increasing value may be different than the threshold for triggering latch based on a decreasing value. In one embodiment, the threshold magnitude difference for triggering latch based on an increasing value is greater than the threshold magnitude difference for triggering latch based on a decreasing value. Thereby, the TTE update is more sensitive to decreasing TTE values than it is to increasing TTE values. If either of those conditions are true, then a "1" or true condition is outputted from the respective block 154, 155 and a new value will be latched.

Also as part of the latching logic, block 157 is performed to determine whether a threshold rate of change in the demand 110 has occurred. Here, logic is executed to determine whether a rapid change has occurred in the demand input, such as a significant movement of the throttle lever or tiller handle (or other user input device), that warrants an immediate update in the current-conditioned TTE calculation. For example, the latest demand value 110 may be compared to a filtered demand value, such as generated using a first order lowpass filter, to determine whether a threshold rate of change has occurred. Alternatively, other logic may be executed to determine whether a threshold change has occurred in a predetermined amount of time. The threshold utilized may be a calibratable fixed value, or in some embodiments may be a user-adjustable value to enable a user to adjust how responsive the displayed TTE value is to changes in demand.

If any of the values at blocks 154, 155, or 157 are true, as determined at block 160, then the update condition is met and a new conditioned TTE value is latched at step 162 by passing through the latest output-filtered TTE estimate 145 and making that the new latched TTE estimate value 165. The output-conditioned TTE 168 is then outputted, which will have the same units as the estimated TTE 140 (e.g., minutes).

In various embodiments, the current-conditioned TTE 138 calculated by process 120a or the output-conditioned TTE 168 calculated by process 120b (or 120d or 120e described below) may be outputted as the smoothed TTE value 101 displayed to the user. FIG. 7 demonstrates a further process 120c comprising steps that may be performed as part of the smoothed TTE calculation. A conditioned TTE value is calculated in block 170 based on the total battery current 108 and/or the estimated TTE 140 described above, as well as the demand 110 and/or the propulsion output value 109. For example, process 120a may be performed in block 170 to calculate a current-conditioned TTE 138. Alternatively or additionally, the process 120b may be performed in block 170 to calculate an output-conditioned TTE 168. Meanwhile, a subtraction factor is determined in block 172 based on demand 110. The outputted subtraction factor may be smaller at smaller demand levels and larger at higher demand levels toward the maximum demand (e.g., 100%), thereby to compensate for greater unknowns and error factors regrading power consumption of the marine drive 3 preforming at high output. For example, block 172 may comprise an index of subtraction factors based on demand values. The subtraction factor is then subtracted from the conditioned TTE at block 174. Step 176 is preformed to make sure that the resulting value is not less than zero, and the smoothed TTE 101 is then outputted and displayed.

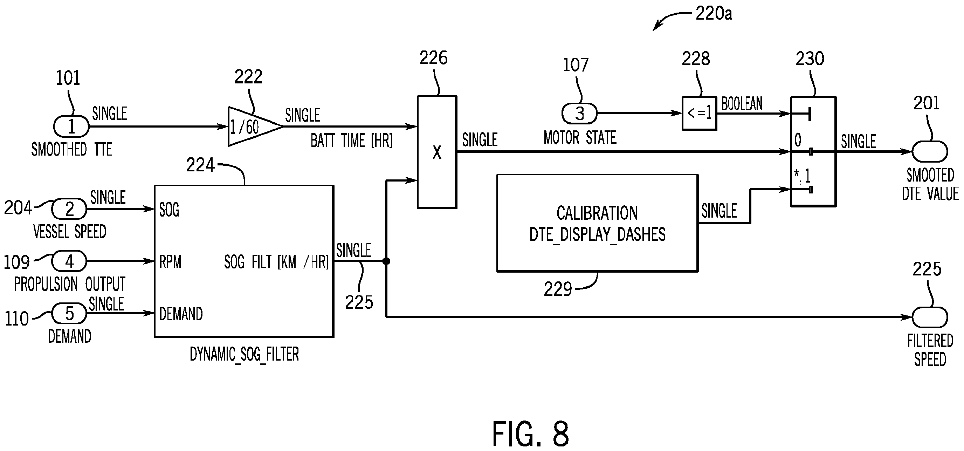

FIG. 8 is a control diagram showing one embodiment of a process 220a performed to calculate a smoothed DTE 201. The process is illustrated using the smoothed TTE value 101 as an input; however, in other embodiments another TTE value may be used, such as an estimated or filtered TTE value calculated by a process other than those described above for calculating smoothed TTE. A filtered vessel speed is calculated at block 224 based on an inputted vessel speed 204, such as a measured speed over ground (e.g., determined based on GPS positions over time) or a measured speed over water (e.g., measured via a vessel speed sensor such as a pitot tube or a paddle wheel). Vessel speed measurements are often noisy and error-prone, particularly at lower speeds where error values are proportionally larger. In the depicted embodiment, a dynamic filter is applied to the vessel speed input 204 to calculate the filtered vessel speed 225, thereby enabling more aggressive filtering at lower propulsion output and/or demand values where it is needed most. A filter is selected and applied at block 224 based on the propulsion output value 109 and/or the demand 110. An exemplary embodiment of a process 224a for determining and applying a dynamic speed filter. However, in other embodiments, the filtered vessel speed 225 may be determined using a static filter. In still other embodiments, particularly where a reliable and stable vessel speed value is available, the value may not need to be filtered and the filtering step may be eliminated altogether.

A DTE value is calculated at block 226 based on the filtered vessel speed 225 and the smoothed TTE value 101 (or other TTE value as described above). Where the smoothed TTE value 101 is in minutes and the vessel speed 204 is reported in hours, a conversion may be performed to align the units. Here, step 222 is be performed to divide the smoothed TTE value 101 by sixty to convert to hours from minutes. The converted smoothed TTE value is then multiplied by the filtered vessel speed 225 to get a distance value, which is the smoothed DTE value. Additional steps may be executed to make sure that the smoothed DTE value is only shown when relevant, for example, that a distance to empty value is not shown when the vessel is stationary (which may be zero if the speed is zero). Here, logic block 228 is executed to determine whether the motor state 107 indicates that the motor is off, or not running. If so, then the calculated DTE value is not passed through at block 230 and thus is not displayed. For example, a calibratable value 229 or notation may be passed through at block 230, such as dashes or "NA" or some other value to indicate to the user that the distance to empty calculation is not applicable based on the present vessel state and speed. Provided that the motor state 107 indicates that the motor 4 is running, then the smoothed DTE value 201 is passed through and displayed.

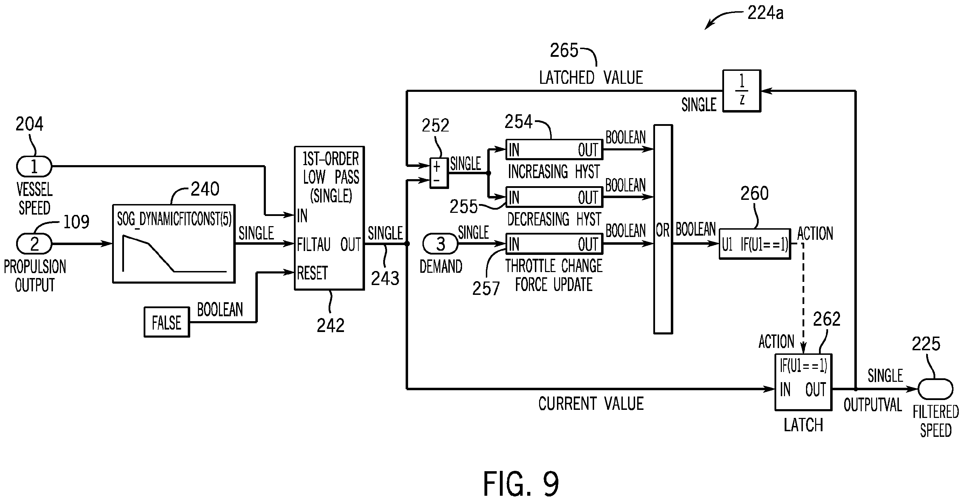

FIG. 9 is a control diagram illustrated one embodiment of a process 224a for calculating filtered speed 225 based on a measured vessel speed 204 (such as a measured speed over ground or speed over water). A dynamic filter is selected at block 240 based on the propulsion output value 109, such as based on motor RPM, motor current, or motor torque. For example, filter parameters (e.g., filter length) may be indexed based on propulsion output values to provide more aggressive filtering at low speed values than at higher speed values. For example, the filter applied when the vessel is at low cruising speeds may be longer than the filter applied when the vessel is cruising on plane. The selected filter is applied to the vessel speed 204 at block 242 to generate an initial filtered vessel speed 243.

The initial filtered vessel speed 243 is then subjected to latching logic similar to that described above to generate the filtered vessel speed 225 utilized for determining the smoothed DTE value 201. The initial filtered vessel speed 243 is passed to difference block 252 which calculates a difference between the latest initial filtered vessel speed 243 and a latched vessel speed 265. The difference outputted from block 252 is assessed at the increasing hysteresis block 254 and decreasing hysteresis block 255, which are configured to assess whether a threshold change has occurred. Namely, the difference value is compared to a speed increase threshold at block 254 to identify whether the initial filtered vessel speed 243 has increased by a predetermined material threshold. The difference value is compared to a speed decrease threshold at block 255 to identify whether the initial filtered vessel speed 243 has decreased by a predetermined material threshold. The speed increase threshold and speed decrease threshold values may be individually definable such that they can differ-i.e., the threshold for triggering latch based on an increasing value may be different than the threshold for triggering latch based on a decreasing value. If either of those conditions are true, then a "1" or true condition is outputted from the respective block 254, 255 and a new speed value will be latched.

Also as part of the latching logic, block 257 is performed to determine whether a threshold rate of change in the demand 110 has occurred. As described above, this logic is executed to determine whether a rapid change has occurred in the demand input, such as a significant movement of the throttle lever or tiller handle (or other user input device), that warrants an immediate update in the current-conditioned TTE calculation. For example, the latest demand value 110 may be compared to a filtered demand value, such as generated using a first order lowpass filter, to determine whether a threshold rate of change has occurred. Alternatively, other logic may be executed to determine whether a threshold change has occurred in a predetermined amount of time. The threshold utilized may be a calibratable fixed value, or in some embodiments may be a user-adjustable value to enable a user to adjust how responsive the displayed TTE value is to changes in demand. Alternatively or additionally, the update condition may be engagement or disengagement of an over-torque state providing boosted propulsion output for a short duration to accelerate the marine vessel.

If any of the values at blocks 254, 255, or 257 are true, as determined at block 260, then the update condition is met and a new speed value is latched at step 262 by passing through the latest initial filtered vessel speed 243 and making that the new latched filtered vessel speed 225, which is then utilized to calculate the smoothed DTE value 201.

In certain embodiments, the smoothed TTE calculation may be configured to account for activation and/or deactivation of an over-torque functionality, or boosted torque output, where the motor is provided with additional power during acceleration compared to the maximum continuous power level available for sustained propulsion output. This short duration of increased power consumption during the over-torque state can cause the TTE to be latched too conservatively. This is particularly problematic where the increasing hysteresis block 154 is less sensitive than the decreasing hysteresis block 155, and thus may latch at a lowered TTE calculated during the over-torque state and may not unlatch once the over-torque state is disengaged.

To address this issue, the system may be configured to account for engagement and/or disengagement of the over-torque state, which may be performed in several ways. In one embodiment, the system is configured to reset the latched TTE/DTE at the conclusion of the over-torque state. Alternatively or additionally, the system may be configured to unlatch the TTE/DTE value such that the range values are continually updated during the over-torque mode and the TTE and DTE values are not relatched until after the over-torque state is disengaged and the power usage by the motor has reached a steady state.

FIG. 10 is a control diagram 120d showing one embodiment for calculating a smoothed TTE that is configured to account for engagement and/or disengagement of the over-torque state by showing the live TTE calculation during and for a period after the over-torque function is performed. As part of the latching logic, block 158 is provided to indicate whether the boosted torque mode engaged, and thus whether the over-torque function is being performed where the motor is consuming additional energy for a short period to accelerate the vessel. Here, if the over-torque mode is engaged, then the output of block 158 will be true (or 1) and if the mode is not engaged the output will be zero.

If any of the values at blocks 154, 155, 157, or 158 are true, then the output of the "OR" Boolean is also true and the output of block 160 is true. The update condition is thus met and a new conditioned TTE value is latched at step 162 by passing through the latest output-filtered TTE estimate 145 and making that the new latched TTE estimate value 165. The output-conditioned TTE 168 is then outputted (e.g., in minutes). The output-conditioned TTE 168 calculated by process 120c may be outputted as the smoothed TTE value 101 displayed to the user. Likewise, the DTE may be calculated based on the TTE, as described above. Thus, the displayed TTE and/or DTE would immediately and continually update on the display while the boost mode is engaged. Thus, the user will see a significant decrease in the displayed TTE/DTE value while the over-torque is being performed, and the displayed TTE/DTE value will rise again once boost mode is disengaged.

In some implementations, it may be desirable not to show the live TTE or DTE value while the over-torque function is being performed because the live-calculated TTE/DTE value will be artificially low during that time. Since the over-torque is only performed and permitted for a short period, and since performance of the over-torque functions requires more energy to be drawn from the battery than any steady state output of the motor, the time-remaining and/or distance remaining values calculated during over-torque performance will not accurately reflect the time-remaining or distance-remaining for vessel propulsion based on the current batter level.

Accordingly, the system may be configured to freeze the TTE and/or DTE values while the torque is being boosted, and update the values once the over-torque is completed and the energy consumption by the motor returns to a value that can be maintained at steady state. FIG. 11 is a control diagram 120e showing an embodiment for calculating a smoothed TTE that is configured to account for engagement and/or disengagement of the over-torque state by not updating the TTE while the torque is being boosted and waiting until a reliable value is calculated after completion of the over-torque. Here, block 158 is placed after the OR logic and the output to the logic block 160 is modified when the boost mode is engaged to not permit the value to update while the boost mode is engaged.

As described above, block 158 is configured to indicate whether the boosted torque mode engaged, and thus whether the over-torque function is being performed where the motor is consuming additional energy for a short period to accelerate the vessel. Thus, if the over-torque mode is engaged, then the output of block 158 will be true (or 1) and if the mode is not engaged the output will be zero. However, the output of block 158 is inverted, thus a false (or 0) will be provided to logic block 159 when the boost function is engaged and a true (or 1) will be provided when the boost function is engaged. Logic block 159 acts an AND gate, and thus if the boost function is engaged then the output of block 159 will always be false (or 0) and the new value will not be passed through as an updated TTE. The conditioned TTE value will not update until the boosted torque ends (block 158 outputs zero) and any of the values at blocks 154, 155, or 157 are true. Thus, the displayed TTE and/or DTE will be frozen while over-torque is being effectuated and will not update on the display until after the boosted torque ceases.

In the present description, certain terms have been used for brevity, clarity, and understanding. No unnecessary limitations are to be implied therefrom beyond the requirement of the prior art because such terms are used for descriptive purposes only and are intended to be broadly construed. The different apparatuses, systems, and methods described herein may be used alone or in combination with other apparatuses systems, and methods. Various equivalents, alternatives and modifications are possible within the scope of the appended claims.

## Claims

1. An electric marine propulsion system (2), the system (2) comprising:
a power storage system (16) comprising at least one marine battery (18a-d);
an electric marine drive (3) powered by the power storage system (16);
a display (40);
a control system (11) configured to:
receive a reported time to empty (reported TTE) from each of the at least one battery (18a-d) and/or receive a battery current from each of the at least one battery (18a-d);
detect an update condition;
upon detection of the update condition, update at least one of a smoothed time to empty (smoothed TTE) value (101) and a smoothed distance to empty (smoothed DTE) value (201) for the power storage system (16) based on the reported TTE and/or the battery current from each of the at least one battery (18a-d); and
control the display (40) to display the smoothed TTE value (101) and/or the smoothed DTE value (201).

2. The system (2) of claim 1, wherein the detected update condition includes at least one of a threshold change in demand, a neutral motor state, a threshold change in battery current, a threshold change in a filtered TTE value, or a threshold change in vessel speed, optionally wherein the change in demand is one of a threshold change in demand magnitude since the value and/or the smoothed DTE value (201) was last updated or a threshold rate of change in demand.

3. The system (2) of claim 1 or 2, wherein the update condition includes at least one of engagement of an over-torque state or disengagement of the over-torque state.

4. The system (2) of claim 1, 2 or 3, wherein the control system (11) is further configured to:
determine an estimated TTE (140) based on the reported TTE from all of the at least one battery (18a-d) and/or based on a battery current received from all of the at least one battery (18a-d);
filter the estimated TTE (140) with a filter (144) selected based on a propulsion output value (109) to generate a filtered TTE estimate (145);
upon detection of the update condition, pass through the filtered TTE estimate (145) at a time of detecting the update condition to generate an output-conditioned time to empty (output-conditioned TTE) (168) as the smoothed TTE value (101); and
control the display (40) to display the smoothed TTE value (101).

5. The system (2) of claim 4, wherein filtering the estimated TTE (140) includes applying a longer filter (144) when the propulsion output value (109) is low than when the propulsion output value (109) is high and/or wherein a filter length of the selected filter (144) progressively decreases as the propulsion output value (109) increases.

6. The system (2) of claim 4 or 5, wherein the propulsion output value (109) includes at least one of a motor RPM, a motor current, and a motor torque of a powerhead of the electric marine drive (3).

7. The system (2) of claim 4, 5 or 6, wherein the estimated TTE (140) is a total reported TTE (106) calculated as an average or a filtered average of the reported TTE from all of the at least one battery (18a-d) and/or wherein the estimated TTE (140) is a current-conditioned time to empty (current-conditioned TTE) (138) calculated based on a battery current received from all of the at least one battery (18a-d).

8. The system (2) of any one of the preceding claims, wherein the control system (11) is further configured to calculate the smoothed DTE value (201) based on the smoothed TTE value (101) and control the display (40) in real time to update the smoothed TTE value (101) and the smoothed DTE value (201).

9. The system (2) of any one of the preceding claims, wherein the control system (11) is further configured to:
determine a total battery current (108) being drawn from the power storage system (16) and a total capacity remaining (104) for the power storage system (16);
upon detection of the update condition, pass through the total battery current (108) at a time of detecting the update condition;
calculate a current-conditioned TTE (138) for the marine battery (18a-d) based on the total battery current (108) and the total capacity remaining (104) as the smoothed TTE value (101); and
control the display (40) to display the smoothed TTE value (101).

10. The system (2) of any one of the preceding claims, wherein the control system (11) is further configured to:
determine a filtered vessel speed (225) based on a propulsion output value (109);
upon detection of the update condition, pass through the filtered vessel speed (225) at the time of detecting the update condition;
calculating the smoothed DTE value (201) based on the filtered vessel speed (225); and
control the display (40) to display the smoothed DTE value (201).

11. A method of monitoring a power storage system (16) configured to power an electric marine propulsion system (2), the power storage system (16) comprising at least one marine battery (18a-d), the method comprising:
receiving a reported time to empty (reported TTE) from each of the at least one battery (18a-d) and/or receiving a battery current from each of the at least one battery (18a-d);
detecting an update condition;
upon detecting the update condition, updating at least one of a smoothed time to empty (smoothed TTE) value (101) and a smoothed distance to empty (smoothed DTE) value (201) for the power storage system (16) based on the reported TTE and/or the battery current from each of the at least one battery (18a-d); and
controlling a display (40) to display the smoothed TTE value (101) and/or the smoothed DTE value (201).

12. The method of claim 11, wherein detecting the update condition includes detecting at least one of a threshold change in demand, a neutral motor state, a threshold change in battery current, a threshold change in a filtered TTE value, or a threshold change in vessel speed, optionally wherein the change in demand is one of a threshold change in demand magnitude since the value and/or the smoothed DTE value (201) was last updated or a threshold rate of change in demand.

13. The method of claim 11 or 12, further comprising:
determining an estimated time to empty (estimated TTE) (140) based on the reported TTE from all of the at least one battery (18a-d) and/or based on a battery current received from all of the at least one battery (18a-d);
filtering the estimated TTE (140) with a filter (144) selected based on a propulsion output value (109) to generate a filtered TTE estimate (145);
upon detection of the update condition, passing through the filtered TTE estimate (145) at a time of detecting the update condition to generate an output-conditioned time to empty (output-conditioned TTE) (168) as the smoothed TTE value (101); and
controlling the display (40) to display the smoothed TTE value (101),
optionally further comprising calculating a total reported TTE (106) based on the reported TTE from each of the at least one battery (18a-d), and wherein the update condition includes a threshold increase in the total reported TTE (106), a threshold decrease in the total reported TTE (106), and a threshold rate of change in demand.

14. The method of claim 11, 12 or 13, further comprising:
determining a total battery current (108) being drawn from the power storage system (16) and a total capacity remaining (104) for the power storage system (16);
upon detection of the update condition, passing through the total battery current (108) at a time of detecting the update condition;
calculating a current-conditioned time to empty (current-conditioned TTE) (138) for the marine battery (18a-d) based on the total battery current (108) and the total capacity remaining (104) as the smoothed TTE value (101); and
controlling the display (40) to display the smoothed TTE value (101).

15. The method of any one of claims 11-14, wherein the update condition further includes at least one of engagement of an over-torque state or disengagement of the over-torque state.
